# EUROPEAN PATENT APPLICATION

(11) **EP 4 760 785 A1**
(43) Date of publication of application: **17.06.2026**
(21) Application number: 23948570.9
(22) Date of filing: 10.08.2023
(51) Int. Cl.: H01L 25/075, H10H 20/855, H10H 20/851, H10H 20/85, H10H 20/853, G02F 1/1333

(54) **DISPLAY DEVICE**

(71) Applicant: LG Electronics Inc., Yeongdeungpo-gu Seoul 07336 (KR)
(72) Inventor: SHIM, Seunghwan, Seoul 06772 (KR); JUNG, Yongmin, Seoul 06772 (KR); JUNG, Moongu, Seoul 06772 (KR)
(74) Representative: Schornack, Oliver
(86) International application number: PCT/KR2023/011821
(87) International publication number: WO 2025/033575

(57) **Abstract**

A display device is disclosed. The display device of the present disclosure may include: a display panel; a frame positioned at the rear of the display panel; a substrate positioned between the display panel and the frame and coupled to the frame; a light source positioned on the substrate and providing light to the display panel; a housing positioned on the substrate and surrounding the side surfaces of the light source; and a light conversion layer positioned inside the housing and facing the light source, wherein the housing may include: an air gap formed between the light conversion layer and the light source; and a hole formed through a side surface of the housing and communicating with the air gap.

## Description

### TECHNICAL FIELD

The present disclosure relates to a display device.

### BACKGROUND ART

As the information society develops, the demand for display devices is also increasing in various forms, and in response to this, various display devices, such as Liquid Crystal Display Device (LCD), Plasma Display Panel (PDP), Electro luminescent Display (ELD), Vacuum Fluorescent Display (VFD), and Organic Light Emitting Diode (OLED), have been studied and used recently.

Among these, the LCD panel has TFT substrate and color substrate that are opposite to each other with a liquid crystal layer interposed therebetween, and may display images by using light provided from a backlight unit.

Recently, as interest in the image quality of display devices has increased, color expression or color reproducibility close to true colors has received significant attention, and much research is being conducted on improving image quality to implement true colors.

### DETAILED DESCRIPTION OF INVENTION

### TECHNICAL PROBLEMS

An object of the present disclosure is to solve the aforementioned problems and other problems.

Another object of the present disclosure may be to provide a display device capable of improving image quality.

Another object of the present disclosure may be to provide a display device having a light conversion layer that converts the color of light from a light source around the light source, instead of a light absorption layer that converts the color of light from the light source.

Another object of the present disclosure may be to provide a structure capable of minimizing deterioration due to heat of a light conversion layer.

Another object of the present disclosure may be to provide a structure capable of improving light efficiency.

### TECHNICAL SOLUTION

According to an aspect of the present disclosure for achieving the above or other object, a display device may include: a display panel; a frame positioned at a rear of the display panel; a substrate which is positioned between the display panel and the frame, and which is coupled to the frame; a light source which is positioned on the substrate, and which provides light to the display panel; a housing which is positioned on the substrate, and which surrounds a side surface of the light source; and a light conversion layer which is positioned inside the housing, and which faces the light source, in which the housing may include: an air gap formed between the light conversion layer and the light source; and a hole which is formed through a side surface of the housing, and communicates with the air gap.

### EFFECT OF INVENTION

The effects of the display device according to the present disclosure are described as follows.

According to at least one of embodiments of the present disclosure, there may be provided a display device capable of improving image quality.

According to at least one of embodiments of the present disclosure, there may be provided a display device having a light conversion layer that converts the color of light from a light source around the light source, instead of a light absorption layer that converts the color of light from the light source.

According to at least one of embodiments of the present disclosure, there may be provided a structure capable of minimizing deterioration due to heat of a light conversion layer.

According to at least one of embodiments of the present disclosure, there may be provided a structure capable of improving light efficiency.

Further scope of applicability of the present disclosure will become apparent from the following detailed description. However, it should be understood that the detailed description and specific embodiments such as preferred embodiments of the present disclosure are given by way of illustration only, since various changes and modifications within the spirit and scope of the present disclosure may be clearly understood by those skilled in the art.

### BRIEF DESCRIPTION OF THE DRAWING

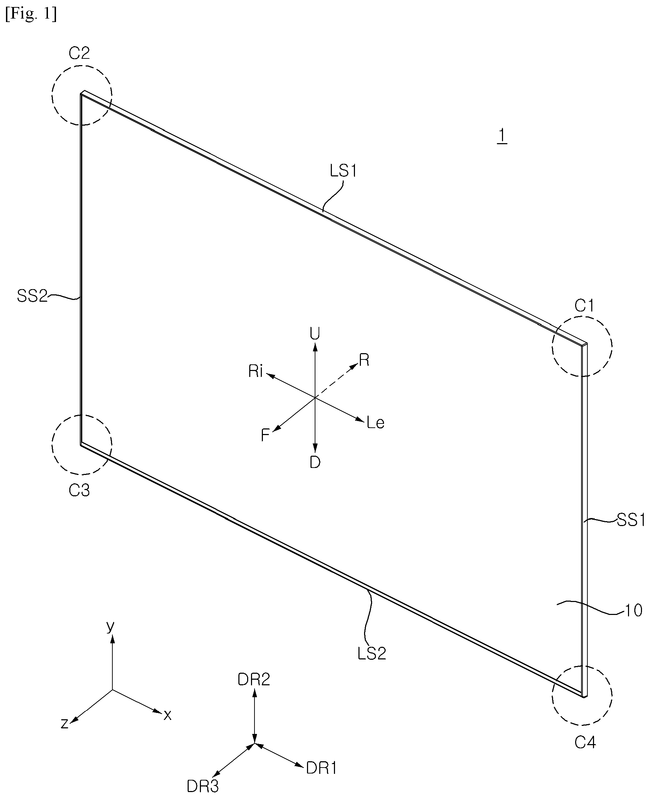

FIGS. 1 to 15 are drawings illustrating examples of a display device according to embodiments of the present disclosure.

### MODE FOR CARRYING OUT THE INVENTION

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In general, suffixes such as "module" and "unit" may be used to refer to elements or components. Use of such suffixes herein is merely intended to facilitate description of the specification, and the suffixes do not have any special meaning or function.

In the present disclosure, that which is well known to one of ordinary skill in the relevant art has generally been omitted for the sake of brevity. The accompanying drawings are used to assist in easy understanding of various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are only used to distinguish one element from another.

It will be understood that when an element is referred to as being "connected with" another element, there may be intervening elements present. In contrast, it will be understood that when an element is referred to as being "directly connected with" another element, there are no intervening elements present.

A singular representation may include a plural representation unless context clearly indicates otherwise.

In the present application, it should be understood that the terms "comprises, includes," "has," etc. specify the presence of features, numbers, steps, operations, elements, components, or combinations thereof described in the specification, but do not preclude the presence or addition of one or more other features, numbers, steps, operations, elements, components, or combinations thereof.

The direction indications of up U, down D, left Le, right Ri, front F, and rear R shown in the drawings are only for the convenience of explanation, and the technical concepts disclosed in this specification are not limited thereby.

Referring to FIG. 1, a display device 1 may include a display panel 10. The display panel 10 may display an image.

The display device 1 may include a first long side LS1, a second long side LS2 opposite to the first long side LS1, a first short side SS1 adjacent to the first long side LS1 and the second long side LS2, and a second short side SS2 opposite to the first short side SS1. Meanwhile, for convenience of explanation, it is illustrated and described that the lengths of the first and second long sides LS1, LS2 are longer than the lengths of the first and second short sides SS1, SS2, but it may also be possible that the lengths of the first and second long sides LS1, LS2 are approximately equal to the lengths of the first and second short sides SS1, SS2.

The direction parallel to the long sides LS1, LS2 of the display device 1 may be referred to as a left-right direction or a first direction DR1. The direction parallel to the short sides SS1, SS2 of the display device 1 may be referred to as an up-down direction or a second direction DR2. The direction perpendicular to the long sides LS1, LS2 and the short sides SS1, SS2 of the display device 1 may be referred to as a front-rear direction or a third direction DR3.

The direction in which the display panel 10 displays an image may be referred to as a forward direction (F, z), and the opposite direction may be referred to as a rearward direction R. The first long side LS1 side may be referred to as an upper side (U, y), and the second long side LS2 side may be referred to as a lower side D. The first short side SS1 side may be referred to as a left side (Le, x), and the second short side SS2 side may be referred to as a right side Ri.

The first long side LS1, the second long side LS2, the first short side SS1, and the second short side SS2 may be referred to as edges of the display device 1. The point where the first long side LS1, the second long side LS2, the first short side SS1, and the second short side SS2 meet may be referred to as a corner.

The point where the first short side SS1 and the first long side LS1 meet may be referred to as a first corner C1. The point where the first long side LS1 and the second short side SS2 meet may be referred to as a second corner C2. The point where the second short side SS2 and the second long side LS2 meet may be referred to as a third corner C3. The point where the second long side LS2 and the first short side SS1 meet may be referred to as a fourth corner C4.

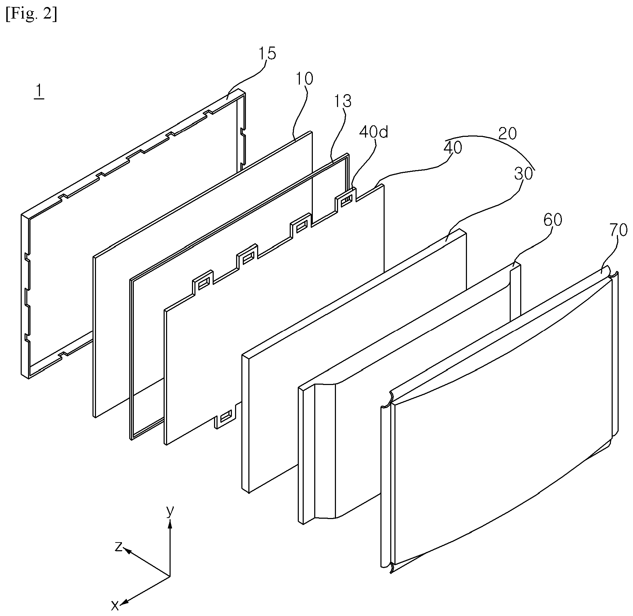

Referring to FIG. 2, the display device 1 may include a display panel 10, a front cover 15, a guide panel 13, a backlight unit 20, a frame 60, and a back cover 70.

The display panel 10 may form the front surface of the display device 1, and display an image. The display panel 10 may display an image by having multiple pixels that output Red, Green, or Blue (RGB) for each pixel in a timely manner. The display panel 10 may be divided into an active area where an image is displayed and a de-active area where no image is displayed. The display panel 10 may include front substrate and rear substrate that are opposite to each other with a liquid crystal layer interposed therebetween. The display panel 10 may be referred to as an LCD panel.

The front substrate may include a plurality of pixels composed of red, green, and blue sub-pixels. The front substrate may output light corresponding to the color of red, green, or blue in response to a control signal.

The rear substrate may include switching elements. The rear substrate may switch a pixel electrode. For example, the pixel electrode may change the molecular arrangement of the liquid crystal layer in response to an externally input control signal. The liquid crystal layer may include liquid crystal molecules. The arrangement of the liquid crystal molecules may change in response to a voltage difference generated between the pixel electrode and a common electrode. The liquid crystal layer may transmit a light provided by the backlight unit 20 to the front substrate or block the light.

The front cover 15 may cover at least a portion of the front and side surfaces of the display panel 10. The front cover 15 may be divided into a front cover positioned on the front surface of the display panel 10 and a side cover positioned on the side surface. At least one of the front cover and the side cover may be omitted.

The guide panel 13 may surround the periphery of the display panel 10 and cover the side surface of the display panel 10. The guide panel 13 may be coupled to the display panel 10 or may support the display panel 10.

The backlight unit 20 may be positioned at the rear of the display panel 10. The backlight unit 20 may include light sources. The backlight unit 20 may be coupled to the frame 60 at the front of the frame 60. The backlight unit 20 may be driven by a full drive method or a partial drive method such as local dimming or impulsive driving. The backlight unit 20 may include an optical sheet 40 and an optical layer 30.

The optical sheet 40 may evenly transmit light from a light source to the display panel 10. The optical sheet 40 may be composed of multiple layers. For example, the optical sheet 40 may include a prism sheet or a diffusion sheet. For example, the optical sheet 40 may be a double brightness enhancement film (DBEF). Meanwhile, a coupling portion 40d of the optical sheet 40 may be coupled to the front cover 15, the frame 60, or the back cover 70.

The frame 60 may be positioned at a rear of the backlight unit 20, and may support the components of the display device 1. For example, components, such as a backlight unit 20, and a Printed Circuit Board (PCB) on which multiple electronic devices are positioned, may be coupled to the frame 60.

The back cover 70 may cover the rear of the frame 60. The back cover 70 may be coupled to the frame 60 and/or the front cover 15.

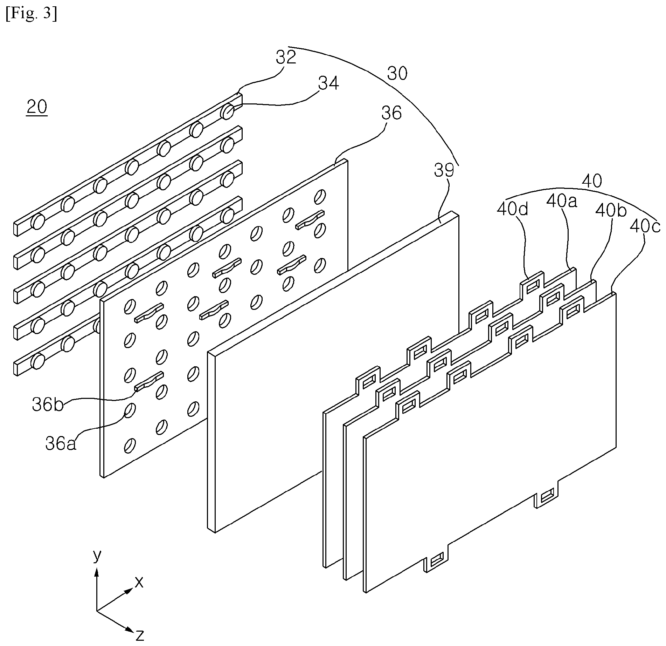

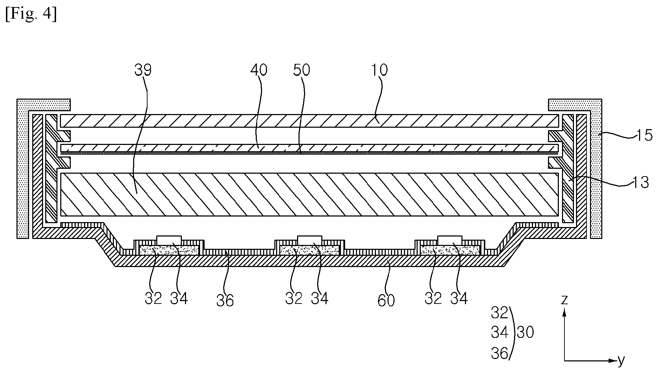

Referring to FIGS. 3 and 4, the backlight unit 20 may include an optical layer 30 and an optical sheet 40. The optical layer 30 may include a substrate 32, at least one light source 34, a reflection sheet 36, and a diffusion plate 39.

The substrate 32 may be coupled to the front surface of the frame 60. The substrate 32 may have a plate shape or may be composed of a plurality of straps spaced apart from each other in the vertical direction. Alternatively, the substrate 32 may have a fork shape having an elongated first plate and a plurality of second plates intersecting with the first plate. The substrate 32 may be composed of at least one of polyethylene terephthalate (PET), glass, polycarbonate (PC), and silicon. The substrate 32 may be a printed circuit board PCB.

At least one light source 34 may be mounted on the substrate 32. The plurality of light sources 34 may be spaced apart from each other on the substrate 32. An electrode pattern for connecting an adapter and the light source 34 may be formed on the substrate 32. For example, a carbon nanotube electrode pattern for connecting the light source 34 and the adapter may be formed on the substrate 32.

For example, the light source 34 may be a light emitting diode (LED) chip or a light emitting diode package including at least one light emitting diode chip. The light source 34 may be a colored LED that emits at least one color, such as red, green, and blue, or may be composed of a white LED. The colored LED may include at least one of a red LED, a green LED, and a blue LED. The light source 34 may be referred to as an optical assembly 34.

The reflection sheet 36 may be positioned in front of the substrate 32. The reflection sheet 36 may be positioned on an area of the substrate 32 excluding an area where the light source 34 is formed. The reflection sheet 36 may have a hole 36a in which the light source 34 is positioned.

In addition, the reflection sheet 36 may include at least one of a metal and a metal oxide which are a reflection material. For example, the reflection sheet 36 may include a metal having a high reflectivity, such as at least one of aluminum Al, silver Ag, gold Au, and titanium dioxide TiO2 and/or a metal oxide. For example, a resin may be deposited or coated on the light source 34 and/or the reflection sheet 36. The resin may diffuse the light of the light source 34. Accordingly, the reflection sheet 36 may reflect the light of the light source 34 or the light reflected from the diffusion plate 39 in a forward direction.

The diffusion plate 39 may be positioned in front of the reflection sheet 36. The diffusion plate 39 may diffuse the light of the light source 34. The supporter 36b may be positioned between the reflection sheet 36 and the diffusion plate 39, and may support the rear surface of the diffusion plate 39. Accordingly, an air gap may be formed between the reflection sheet 36 and the diffusion plate 39, and the light from the light source 34 may be widely spread by the air gap. The diffusion plate 39 may be referred to as an optical plate 39.

The optical sheet 40 may be positioned in front of the diffusion plate 39. The rear surface of the optical sheet 40 may be in close contact with the diffusion plate 39, and the front surface of the optical sheet 40 may be in close contact with or adjacent to the rear surface of the display panel 10. The optical sheet 40 may include at least one sheet.

For example, the optical sheet 40 may include a plurality of sheets having different functions. A first optical sheet 40a and a second optical sheet 40b may be a prism sheet, and a third optical sheet 40a may be a diffusion sheet. The prism sheet may collect light from the diffusion plate 39 and provide the light to the display panel 10. The diffusion sheet may prevent the light from the diffusion plate 39 from being partially concentrated, thereby making the light distribution more uniform. The number and/or positions of the prism sheet and the diffusion sheet may be changed.

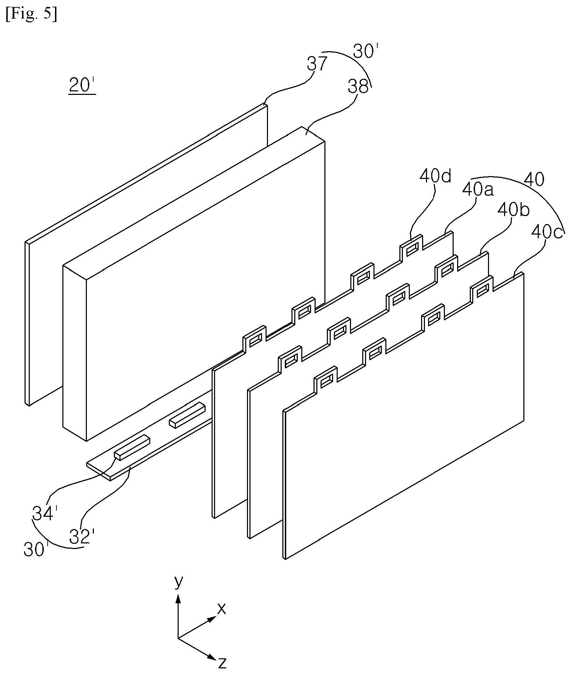

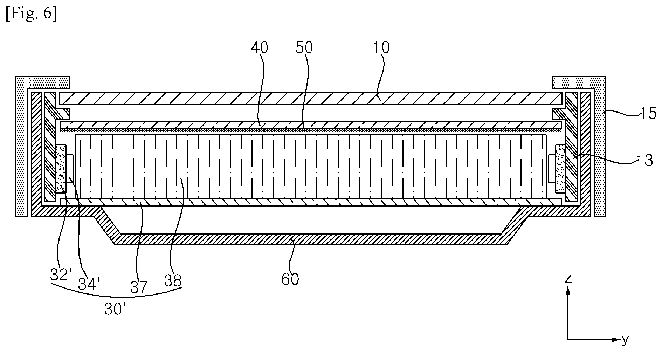

Referring to FIGS. 5 and 6, a backlight unit 20' may include an optical layer 30' and an optical sheet 40. The optical layer 30' may be positioned between the frame 60 and the display panel 10. The optical layer 30' may be supported by the frame 60. The optical layer 30' may include a substrate 32', at least one light source 34', a reflection sheet 37, and a light guide plate 38.

The light guide plate 38 may be positioned between the frame 60 and the optical sheet 40, and may be supported by the frame 60. The light guide plate 38 may be referred to as an optical plate 38.

The substrate 32' may be adjacent to the periphery of the light guide plate 38, and may be coupled to one side of the guide panel 13. For example, the substrate 32' may be adjacent to the lower side of the light guide plate 38. The substrate 32' may be composed of at least one of polyethylene terephthalate (PET), glass, polycarbonate (PC), and silicon. The substrate 32' may be a printed circuit board (PCB).

At least one light source 34' may be mounted on the substrate 32'. A plurality of light sources 34' may be spaced apart from each other on the substrate 32'. An electrode pattern for connecting the adapter and the light source 34' may be formed on the substrate 32'. For example, a carbon nanotube electrode pattern for connecting the light source 34' and the adapter may be formed on the substrate 32'.

For example, the light source 34' may be a light emitting diode (LED) chip or a light emitting diode package including at least one light emitting diode chip. The light source 34' may be a colored LED that emits at least one color among red, green, and blue, or may be a white LED. The colored LED may include at least one of a red LED, a green LED, and a blue LED. The light source 34' may be referred to as an optical assembly 34'.

The reflection sheet 37 may be positioned between the frame 60 and the light guide plate 38, and may be supported by the frame 60. The reflection sheet 37 may include at least one reflective material, among a metal and a metal oxide. For example, the reflection sheet 37 may include a metal and/or a metal oxide having a high reflectivity, such as at least one of aluminum Al, silver Ag, gold Au, and titanium dioxide (TiO2).

Accordingly, the light source 34' may provide light to the edge of the light guide plate 38. Light entering the light guide plate 38 may be directed forward by the light guide plate 38 and the reflection sheet 37.

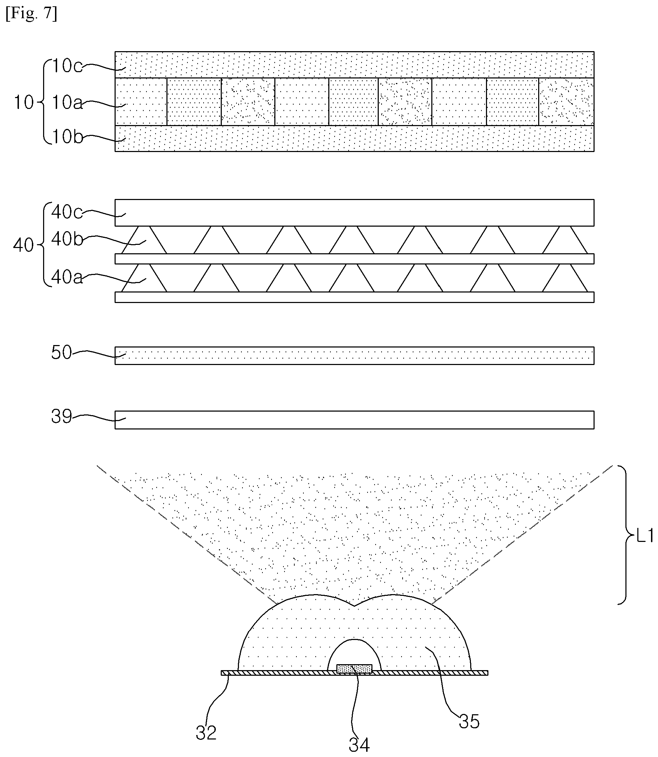

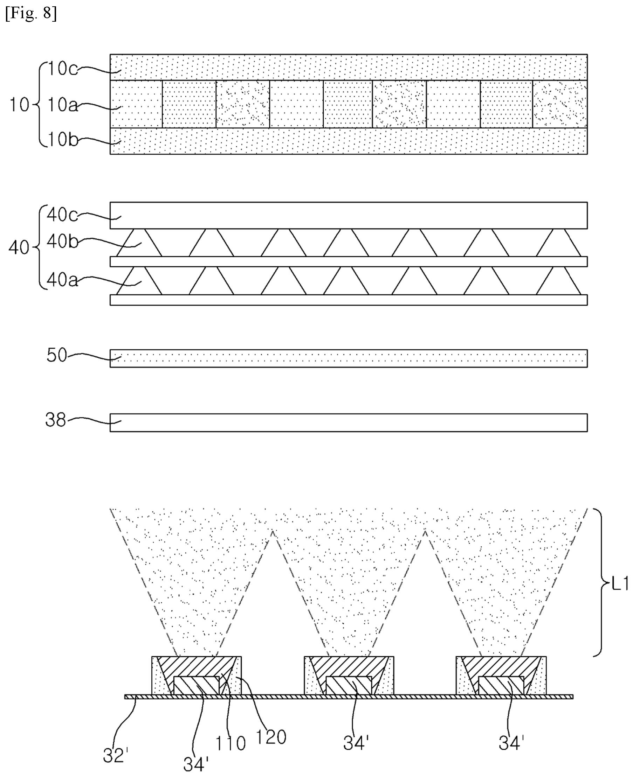

Referring to FIGS. 7 and 8, the display panel 10 may include a front substrate 10c, a rear substrate 10b, and a color filter 10a. The color filter 10a may be positioned between the front substrate 10c and the rear substrate 10b. A liquid crystal layer, and TFT may be additionally added to between the front substrate 10c and the rear substrate 10b. A first polarizing film (not shown) may be positioned on the front surface of the front substrate 10c, and a second polarizing film (not shown) may be positioned on the rear surface of the rear substrate 10b.

The light source 34, 34' may provide light to the optical sheet 40. Light scattered and/or collected from the optical sheet 40 may be provided to the display panel 10. The display panel 10 may display an image using this light.

Referring to FIG. 7, for example, a lens 35 may cover the light source 34, and may be fixed or attached to the substrate 32. The lens 35 may include at least one of silicone, polymethyl methacrylate (PMMA), and polycarbonate (PC).

Referring to FIG. 8, for example, an encapsulation 110 may cover the light source 34'. A cup 120 may be fixed or attached to the substrate 32', and the encapsulation 110 may be filled into a concave groove of the cup 120. The encapsulation 110 may include silicone or a resin material.

A light absorption layer 50 may be positioned on the path of light provided from the light source 34, 34' toward the display panel 10. The light absorption layer 50 may be positioned on the rear surface or front surface of the optical sheet 40. The light absorption layer 50 may be formed, adhered, or deposited the rear surface or front surface of the optical sheet 40. The light absorption layer 50 may be referred to as a various colors sheet 50, and may include a Quantum Dot Enhancement Film (QD film) and/or a Nano Organic Material Film (NOM film).

For example, the light L1 of the light source 34, 34' may be blue light. The light absorption layer 50 may include a green phosphor GP and a red phosphor RP. The green phosphor GP may be a particle (SrGa2S4:Eu) of 3 to 7 micrometers, and the red phosphor RP may be a particle (Sr,CaAISiN3:Eu) of 1 micrometer or less. The green phosphor GP may be referred to as a green quantum dot (green QD), and the red phosphor RP may be referred to as a red quantum dot (red QD).

In this case, the light L1 of the light source 34, 34' may excite the green phosphor GP and the red phosphor RP, the green phosphor GP may emit green light, and the red phosphor RP may emit red light. Accordingly, a portion of the light L1 of the light source 34, 34' may pass through the light absorption layer 50 without being absorbed to or reflected by the green phosphor GP and the red phosphor RP, and may appear as blue light, and may be mixed with the green and red light emitted from the light absorption layer 50 to produce white light.

However, a significant cost may be incurred in manufacturing the light absorption layer 50. In addition, since the light absorption layer 50 is positioned away from the light source 34, 34', light loss may occur. In addition, deformation, such as wrinkles, may occur in the light absorption layer 50 due to heat generated when the backlight unit is operated.

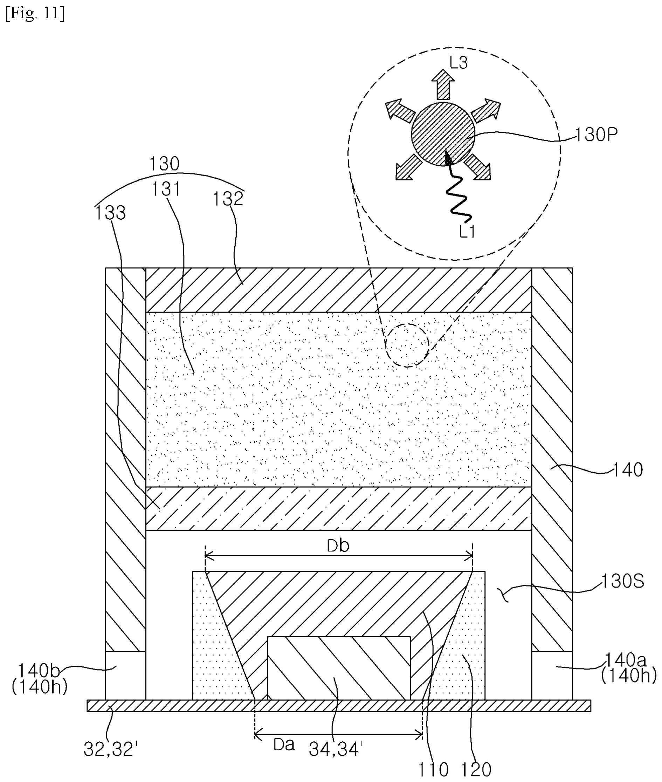

Meanwhile, with reference to FIGS. 11 to 15, a cover 130 having a light conversion layer 131 spaced apart from a light source 34, 34' and a housing 140, 140' to which the cover 130 is coupled, etc. may be provided in place of the light absorption layer 50 having the aforementioned problems.

However, with reference to FIGS. 11 to 15, a cover 130 having a light conversion layer 131 spaced apart from a light source 34, 34' and a housing 140, 140' to which the cover 130 is coupled, etc., has technical significance in itself in preventing deterioration of the light conversion layer 131, and thus may be used to implement white light together with the light absorption layer 50. In this case, compared to a case where the light absorption layer 50 alone implement white light, the concentration of the phosphor in the light absorption layer 50 may be reduced, thereby reducing the cost required for manufacturing the light absorption layer 50.

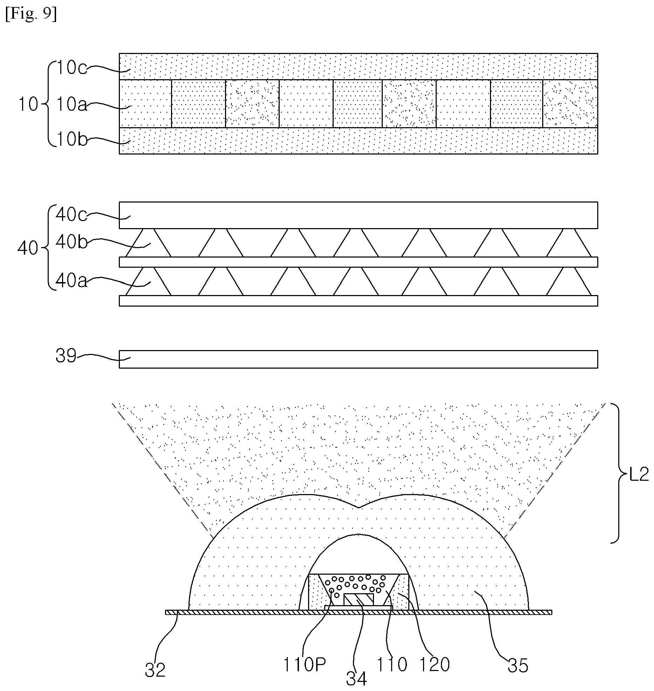

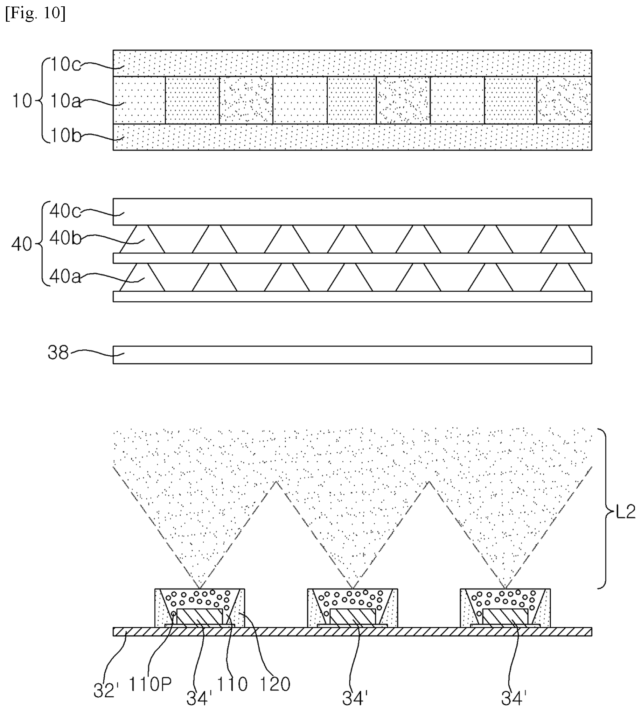

Referring to FIGS. 9 and 10, the phosphor 110P may be positioned around the light source 34, 34', and the aforementioned light absorption layer 50 may be omitted. The phosphor 110P may be in powder form. For example, a liquid encapsulation 110 mixed with the phosphor 110P may cover the light source 34, 34' and be cured.

For example, the light from the light source 34, 34' may be blue light. The phosphor 110P may include a yellow phosphor YP. The phosphor 110P may further include a red phosphor RP. The yellow phosphor YP may be Yttrium Aluminum Garnet (YAG), La3Si6N11, LuAG(Al5Lu3O12), or Silicate in a micrometer unit. The red phosphor RP may be (Sr,Ca)AlSiN3:Eu, or (Sr, Ca, Ba)2SiN8:Eu in a micrometer unit. The yellow phosphor YP may be referred to as a yellow Quantum Dot (yellow QD) YP. The red phosphor RP may be referred to as a red Quantum Dot (red QD) RP.

In this case, the light from the light source 34, 34' may excite the yellow phosphor YP and the red phosphor RP, the yellow phosphor YP may emit yellow light, and the red phosphor RP may emit red light. Accordingly, portion of the light from the light source 34, 34' may pass through the encapsulation 110 without being absorbed to or reflected by the phosphor 110P, and appear as blue light, and may be mixed with the yellow and red light emitted from the phosphor 110P of the encapsulation 110 to implement white light L2.

As another example, the light from the light source 34, 34' may be blue light. The phosphor 110P may include a green phosphor GP and a red phosphor RP. The green phosphor GP may be a particle (SrGa2S4:Eu) of 3 to 7 micrometers, and the red phosphor RP may be a particle (Sr,Ca)AlSiN3:Eu of 1 micrometer or less. The green phosphor GP may be referred to as a green Quantum Dot (green QD) GP, and the red phosphor RP may be referred to as a red Quantum Dot (red QD) RP.

In this case, the light from the light source 34, 34' may excite the green phosphor GP and the red phosphor RP, the green phosphor RP may emit green light, and the red phosphor RP may emit red light. Accordingly, portion of the light from the light source 34, 34' may pass through the encapsulation 110 without being absorbed to or reflected by the phosphor 110P and appear as blue light, and may be mixed with the green and red light emitted from the phosphor 110P to implement white light.

However, the heat from the light source 34, 34' may be transferred to the phosphor 110P that comes into contact with the light source 34, 34', so that the phosphor 110P may be deteriorated.

Referring to FIG. 11, the light source 34, 34' may be mounted on the substrate 32, 32' in a Chip Scale Package (CSP) manner.

The cup 120 may surround the side of the light source 34, 34', and may be coupled or attached to the substrate 32, 32'. The width (diameter) of the inner space of the concave groove shape of the cup 120 may gradually increase in the direction of light propagation from the light source 34, 34'. The inner surface of the cup 120 may be referred to as a guide wall (or surface), may have a minimum width Da (minimum diameter) at a point closest to the substrate 32, 32', and a maximum width Db (maximum diameter) at a point farthest from the substrate 32, 32'. The cup 120 may include a silicone or resin material. Light may not be able to penetrate the cup 120, and the cup 120 may be white.

The encapsulation 110 may fill the interior space of the cup 120. The encapsulation 110 may have an inverted truncated cone shape. The encapsulation 110 may include a silicone or resin material.

Accordingly, light from the light source 34, 34' may penetrate the encapsulation 110, and be guided along the inner surface of the cup 120.

The housing 140 may surround the side surface of the cup 120, and be spaced apart from the side surface of the cup 120. The housing 140 may be coupled or attached to the substrate 32, 32'. The housing 140 may have a hollow cylinder shape or a polygonal column (e.g., a square column) shape. For example, the housing 140 may be formed of a heat-resistant polymer material such as PolyCyclohexylenedimethylene Terephthalate (PCT) or Epoxy Mold Compound (EMC).

The cover 130 may be coupled to or formed on the inner surface of the housing 140, and may face the cup 120 and the encapsulation 110 covering the light source 34, 34'. The cover 130 may be spaced apart from the encapsulation 110 and the cup 120. The cover 130 may include a light conversion layer 131, a light-input portion 133, and a light-output portion 132.

The light conversion layer 131 may be coupled to or formed on the inner surface of the housing 140, and may block a portion of a hollow space of the housing 140. The light conversion layer 131 may have a shape corresponding to a cross-section of the housing 140. The light conversion layer 131 may include a phosphor 130P. The phosphor 130P may be a Quantum Dot (QD) 130P, or a Nano Organic Material (NOM) 130P. The phosphor 130P may be referred to as a light conversion material 130P.

The light-input portion 133 and the light-output portion 132 may be coupled to or formed on the inner surface of the housing 140, and may block a portion of the hollow space of the housing 140. The light-input portion 133 may be positioned between the light conversion layer 131 and the encapsulation 110 covering the light source 34, 34'. The light-output portion 132 may be opposite to the light-input portion 133 with respect to the light conversion layer 131. The light-input portion 133 and the light-output portion 132 may include a transparent material. The light-input portion 133 and the light-output portion 132 may function as an insulating material. For example, the light-input portion 133 and the light-output portion 132 may include a phenyl-based or methyl-based silicone or resin material.

An air gap 130S may be formed around the encapsulation 110 and the cup 120. The inner surface of the housing 140 may be spaced apart from the cup 120 by the air gap 130S. The light-input portion 133 may be spaced apart from the encapsulation 110 by the air gap 130S.

Accordingly, the cover 130 having the light conversion layer 131 may be spaced apart from the encapsulation 110 covering the light source 34, 34' by the air gap 130S, thereby preventing deterioration of the light conversion layer 131. In addition, the light-input portion 133 and the light-output portion 132 may function as insulation for the light conversion layer 131, thereby protecting the light conversion layer 131 from heat.

The hole 140h may be formed to penetrate the side surface of the housing 140, and may be in communication with the air gap 130S. The hole 140h may face the side surface of the cup 120, and may be positioned at a rear (lower side, based on FIG. 11) than the front end of the cup 120 (the upper end of the cup 120, based on FIG. 11). Accordingly, light leakage from the light source 34, 34' through the hole 140h may be minimized. The hole 140h may be referred to as a slit 140h, an air vent 140h, or an air channel 140h.

Accordingly, the air gap 130S may be connected to the external space of the housing 140 through the hole 140h. That is, air may be flowed in from the outside of the housing 140 into the air gap 130S through the hole 140h or discharged from the air gap 130S to the outside of the housing 140. By this airflow, the temperature rise of the air gap 130S may be minimized. In this case, compared to a case where the air gap 130S is formed as a sealed space due to the absence of the hole 140h, it may be advantageous in preventing deterioration of the light conversion layer 131. In addition, in such a structure that minimizes heat transferred to the light conversion layer 131, it may be advantageous in increasing the current value flowing to the light source 34, 34'.

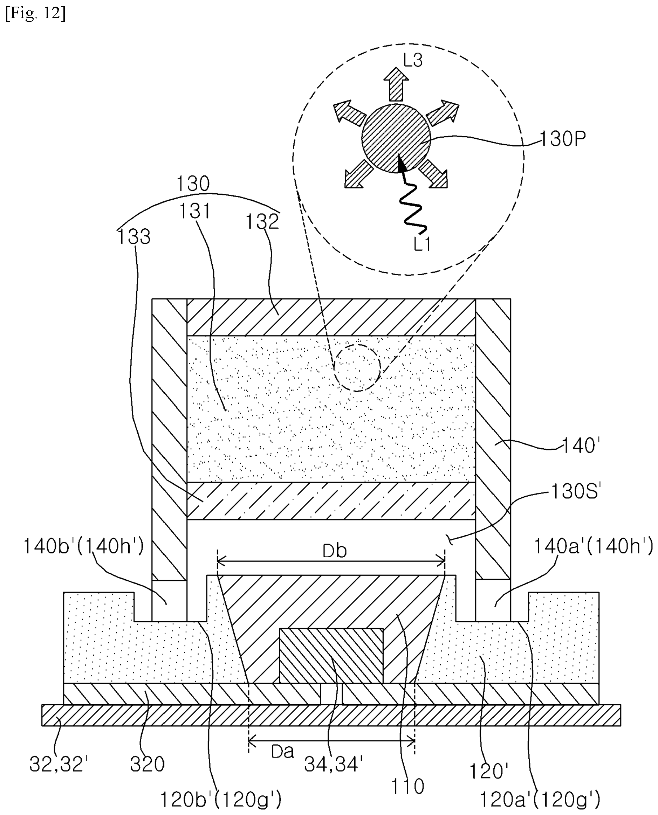

Referring to FIG. 12, the light source 34, 34' may be mounted on the substrate 32, 32' in a Package On Board (POB) manner. In this case, a conductive frame 320 may be disposed between the light source 34, 34' and the substrate 32, 32'.

A cup 120' may surround the side surface of the light source 34, 34' and may be coupled or attached to the frame 320. The width (diameter) of the concave groove-shaped internal space of the cup 120' may gradually increase in the direction of light propagation from the light source 34, 34'. The inner surface of the cup 120' may be referred to as a guide wall (or surface), may have a minimum width Da at a point closest to the frame 320, and have a maximum width (maximum diameter) Db at a point farthest from the frame 320. The cup 120' may include a silicone or resin material. Light may not be able to penetrate the cup 120', and the cup 120' may be white.

The encapsulation 110 may be filled in the inner space of the cup 120'. The encapsulation 110 may have an inverted truncated cone shape. The encapsulation 110 may include a silicone or resin material.

Accordingly, light from the light source 34, 34' may penetrate the encapsulation 110, and be guided along the inner surface of the cup 120.

The housing 140' may be positioned on the cup 120' and may surround a portion of the cup 120'. The housing 140' may be seated on a groove 120g' formed in the cup 120', and an inner surface of the housing 140' may be spaced apart from the cup 120'. The housing 140' may be coupled to or attached to the groove 120g'. The housing 140' may have a hollow cylinder shape or a polygonal column shape (e.g., a square column). For example, the housing 140' may be formed of a heat-resistant polymer material such as Epoxy Mold Compound (EMC) or Polycyclohexylenedimethylene Terephthalate (PCT).

The cover 130 may be coupled to or formed on the inner surface of the housing 140, and may face the encapsulation 110 and the cup 120' that cover the light source 34, 34'. The cover 130 may be spaced apart from the encapsulation 110 and the cup 120'. The cover 130 may include a light conversion layer 131, a light-input portion 133, and a light-output portion 132.

The light conversion layer 131 may be coupled to or formed on the inner surface of the housing 140', and may block a portion of the hollow space of the housing 140'. The light conversion layer 131 may have a shape corresponding to the cross-section of the housing 140'. The light conversion layer 131 may include a phosphor 130P. The phosphor 130P may be a Quantum Dot (QD) 130P or a Nano Organic Material (NOM) 130P. The phosphor 130P may be referred to as a light conversion material 130P.

The light-input portion 133 and the light-output portion 132 may be coupled to or formed on the inner surface of the housing 140', and may block a portion of the hollow space of the housing 140. The light-input portion 133 may be positioned between the light conversion layer 131 and the encapsulation 110 covering the light source 34, 34'. The light-output portion 132 may be opposite to the light-input portion 133 with respect to the light conversion layer 131. The light-input portion 133 and the light-output portion 132 may include a transparent material. The light-input portion 133 and the light-output portion 132 may function as an insulating material. For example, the light-input portion 133 and the light-output portion 132 may include a phenyl-based or methyl-based silicone or resin material.

An air gap 130S' may be formed around the encapsulation 110 and the cup 120'. The inner surface of the housing 140' may be spaced apart from the cup 120' by the air gap 130S'. The light-input portion 133 may be spaced apart from the encapsulation 110 by the air gap 130S'.

Accordingly, the cover 130 having the light conversion layer 131 may be spaced apart from the encapsulation 110 covering the light source 34, 34' by the air gap 130S', thereby preventing deterioration of the light conversion layer 131. In addition, the light-input portion 133 and the light-output portion 132 may function as insulation for the light conversion layer 131, thereby protecting the light conversion layer 131 from heat.

The hole 140h' may be formed by penetrating the side surface of the housing 140', and may be in communication with the air gap 130S'. The hole 140h' may face the side surface of the cup 120', and may be positioned at a rear (lower side, based on FIG. 12) than the front end of the cup 120 (upper end of the cup 120, based on FIG. 12). Accordingly, light leakage from the light source (34, 34') through the hole 140h' may be minimized. The hole 140h' may be referred to as a slit 140h', an air vent 140h', or an air channel 140h'.

Accordingly, the air gap 130S' may be connected to the external space of the housing 140' through the hole 140h'. That is, air may flow into the air gap 130S' from the outside of the housing 140' through the hole 140h' or may be discharged from the air gap 130S' to the outside of the housing 140'. Due to this airflow, the temperature rise of the air gap 130S' may be minimized. In this case, compared to a case where the air gap 130S' is formed as a sealed space without the hole 140h', it may be advantageous in preventing deterioration of the light conversion layer 131. In addition, in a structure that minimizes heat transferred to the light conversion layer 131, it may be advantageous in increasing the current flowing to the light source 34, 34'.

Referring again to FIGS. 11 and 12, light from the light source 34, 34' is guided along the inner surface of the cup 120, 120' and may pass through the encapsulation 110. Then, the light may sequentially pass through the air gap 130S, 130S', the light-input portion 133, the light conversion layer 131, and the light-output portion 132.

For example, the light from the light source 34, 34' may be blue light. The phosphor 130P may include a yellow phosphor YP. The phosphor 130P may further include a red phosphor RP. The yellow phosphor YP may be Yttrium Aluminum Garnet (YAG), La3Si6N11, LuAG(Al5Lu3O12), or Silicate in a micrometer unit. The red phosphor RP may be (Sr,Ca)AlSiN3:Eu, or (Sr, Ca, Ba)2SiN8:Eu in a micrometer unit. Alternatively, the red phosphor RP may be K2SiF6:Mn4+ (KSF). The yellow phosphor YP may be referred to as a yellow Quantum Dot (yellow QD) YP. The red phosphor RP may be referred to as a red Quantum Dot (red QD) RP.

In this case, the light L1 of the light source 34, 34' may excite the yellow phosphor YP and the red phosphor RP, the yellow phosphor YP may emit yellow light, and the red phosphor RP may emit red light. Accordingly, a portion of the light L1 of the light source 34, 34' may pass through the light conversion layer 131 without being absorbed to or reflected by the phosphor 130P and appear as blue light, and may be mixed with the yellow and red light emitted from the phosphor 130P of the light conversion layer 131 to implement white light L3. This white light L3 may be provided to the optical sheet 40 and the display panel 10 (see FIGS. 9 and 10).

For another example, the light from the light source 34, 34' may be blue light. The phosphor 130P may include a green phosphor GP and a red phosphor RP. The green phosphor GP may be a particle (SrGa2S4:Eu) of 3 to 7 micrometers, and the red phosphor RP may be a particle (Sr,CaAlSiN3:Eu) of 1 micrometer or less. The green phosphor GP may be referred to as a green Quantum Dot (green QD) GP, and the red phosphor RP may be referred to as a red Quantum Dot (red QD) RP.

In this case, the light L1 of the light source 34, 34' may excite the green phosphor GP and the red phosphor RP, the green phosphor RP may emit green light, and the red phosphor RP may emit red light. Accordingly, a portion of the light L1 of the light source 34, 34' may pass through the light conversion layer 131 without being absorbed to or reflected by the phosphor 130P and appear as blue light, and may be mixed with the green and red light emitted from the phosphor 130P to implement white light L3. This white light L3 may be provided to the optical sheet 40 and the display panel 10 (see FIGS. 9 and 10).

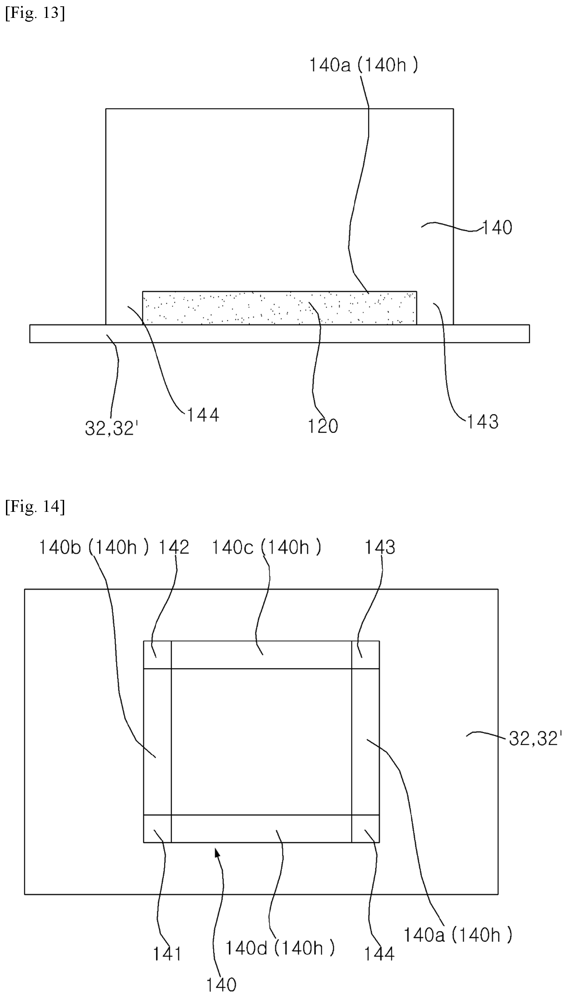

Referring to FIGS. 13 and 14, the housing 140 may have a square column shape. The hole 140h may be formed from one side of the housing 140 positioned on the substrate 32, 32' toward the inside of the housing 140. In this case, a portion of the housing 140 may form a boundary of the hole 140h, may be positioned on the substrate 32, 32', and may be referred to as a leg. For example, the first leg 141, the second leg 142, the third leg 143, and the fourth leg 144 may be formed at a corner of the housing 140, and may be positioned on the substrate 32, 32'. The first hole 140a may be formed between the fourth leg 144 and the third leg 143, and the second hole 140b may be formed between the first leg 141 and the second leg 142. The third hole 140c may be formed between the second leg 142 and the third leg 143, and the fourth hole 140d may be formed between the first leg 141 and the fourth leg 144.

Alternatively, the housing 140 may have a cylindrical shape. The hole 140h may be formed from one side of the housing 140 positioned on the substrate 32, 32' toward the inside of the housing 140, and may have an arc shape. For example, a plurality of holes 140h may be spaced apart from each other in the circumferential direction of the housing 140.

The description of the housing 140 and hole 140h described above with reference to FIGS. 13 and 14 may be identically applied to the housing 140' and hole 140h' of FIG. 12.

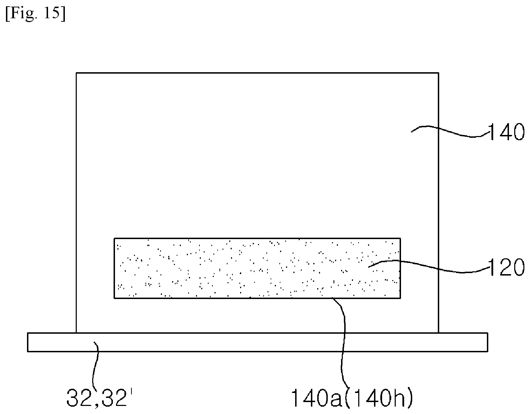

Referring to FIG. 15, the housing 140 may have a polygonal or cylindrical shape. The hole 140h may be formed by penetrating a side surface of the housing 140, and may be spaced apart from the substrate 32, 32'. For example, a plurality of holes 140h may be spaced apart from each other in the circumferential or radial direction of the housing 140.

The description of the housing 140 and hole 140h described above with reference to FIG. 15 may be identically applied to the housing 140' and hole 140h' of FIG. 12.

Referring to FIGS. 1 to 15, a display device according to an aspect of the present disclosure may include: a display panel; a frame positioned at a rear of the display panel; a substrate which is positioned between the display panel and the frame, and which is coupled to the frame; a light source which is positioned on the substrate, and which provides light to the display panel; a housing which is positioned on the substrate, and which surrounds a side surface of the light source; and a light conversion layer which is positioned inside the housing, and which faces the light source, in which the housing may include: an air gap formed between the light conversion layer and the light source; and a hole which is formed through a side surface of the housing, and which communicates with the air gap.

The light conversion layer may include a phosphor that converts a color of light from the light source.

The display device may further include a light-input portion, which is made of a light-transmitting material, which is positioned inside the housing, and which is positioned between the light conversion layer and the light source, and the air gap may be formed between the light-input portion and the light source.

The display device may further include a light-output portion, which is made of a light-transmitting material, which is positioned inside the housing, and which is opposite to the light-input portion with respect to the light conversion layer.

The display device may further include: a cup which is positioned inside the housing, and which surrounds a side surface of the light source; and an encapsulation which is positioned inside the cup, and which covers the light source, and the air gap may be formed around the cup and the encapsulation.

The encapsulation may have an inverted truncated cone shape, and an inner surface of the cup may have a shape corresponding to the encapsulation, and may guide a movement of light from the light source.

The hole may be positioned rearward of a front end of the cup.

The cup may include: a first portion positioned inside the housing; a second portion positioned outside the housing; and a groove which is formed between the first portion and the second portion, and in which the housing is seated.

The housing may have a shape of a cylinder or polygonal column, and the hole may be formed inside the housing from one end of the housing positioned on the substrate, or is positioned spaced apart from the one end of the housing.

The hole may include a plurality of holes spaced apart from each other in a circumferential direction of the housing.

The display device may further include: an optical plate positioned between the display panel and the light source; and an optical sheet positioned between the display panel and the optical plate.

Certain embodiments or other embodiments of the disclosure described above are not mutually exclusive or distinct from each other. Any or all elements of the embodiments of the disclosure described above may be combined or combined with each other in configuration or function.

For example, a configuration "A" described in one embodiment of the disclosure and the drawings and a configuration "B" described in another embodiment of the disclosure and the drawings may be combined with each other. Namely, although the combination between the configurations is not directly described, the combination is possible except in the case where it is described that the combination is impossible.

The foregoing embodiments are merely examples and are not to be considered as limiting the present disclosure. The scope of the present disclosure should be determined by rational interpretation of the appended claims, and all modifications within the equivalents of the disclosure are intended to be included within the scope of the present disclosure.

## Claims

1. A display device comprising:
a display panel;
a frame positioned at a rear of the display panel;
a substrate which is positioned between the display panel and the frame, and which is coupled to the frame;
a light source which is positioned on the substrate, and which provides light to the display panel;
a housing which is positioned on the substrate, and which surrounds a side surface of the light source; and
a light conversion layer which is positioned inside the housing, and which faces the light source,
wherein the housing comprises:
an air gap formed between the light conversion layer and the light source; and
a hole which is formed through a side surface of the housing, and which communicates with the air gap.

2. The display device of claim 1, wherein the light conversion layer comprises a phosphor that converts a color of light from the light source.

3. The display device of claim 1, further comprising a light-input portion, which is made of a light-transmitting material, which is positioned inside the housing, and which is positioned between the light conversion layer and the light source,
wherein the air gap is formed between the light-input portion and the light source.

4. The display device of claim 3, further comprising a light-output portion, which is made of a light-transmitting material, which is positioned inside the housing, and which is opposite to the light-input portion with respect to the light conversion layer.

5. The display device of claim 1, further comprising:
a cup which is positioned inside the housing, and which surrounds a side surface of the light source; and
an encapsulation which is positioned inside the cup, and which covers the light source,
wherein the air gap is formed around the cup and the encapsulation.

6. The display device of claim 5, wherein the encapsulation has an inverted truncated cone shape, and
an inner surface of the cup has a shape corresponding to the encapsulation, and guides a movement of light from the light source.

7. The display device of claim 5, wherein the hole is positioned rearward of a front end of the cup.

8. The display device of claim 5, wherein the cup comprises:
a first portion positioned inside the housing;
a second portion positioned outside the housing; and
a groove which is formed between the first portion and the second portion, and in which the housing is seated.

9. The display device of claim 1, wherein the housing has a shape of a cylinder or polygonal column, and the hole is formed inside the housing from one end of the housing positioned on the substrate, or is positioned spaced apart from the one end of the housing.

10. The display device of claim 1, wherein the hole comprises a plurality of holes spaced apart from each other in a perimeter direction of the housing.

11. The display device of claim 1, further comprising:
an optical plate positioned between the display panel and the light source; and
an optical sheet positioned between the display panel and the optical plate.
